# EUROPEAN PATENT APPLICATION

(11) **EP 4 842 192 A1**
(43) Date of publication of application: **18.11.2026**
(21) Application number: 26173932.0
(22) Date of filing: 22.04.2026
(51) Int. Cl.: H10W 40/25, H10W 40/00, H10W 40/77, H10W 90/20

(54) **HETEROGENOUS DOUBLE-SIDED COOLED PACKAGE USING WITH DIFFERENT DEVICE AND PACKAGE TECHNOLOGIES**

(30) Priority: 13.05.2025 US 202519206735
(71) Applicant: STMicroelectronics International N.V., 1228 Plan-les-Ouates, Geneva (CH)
(72) Inventor: YOO, Inpil, D-82008 Unterhaching (DE); PAUL, Indrajit, D-88677 Markdorf (DE); LEE, Tae Gyun, D-81829 Munich (DE)
(74) Representative: Buzzi, Notaro & Antonielli d'Oulx S.p.A.

(57) **Abstract**

Provided is a hybrid double-sided cooled, DSC, package (100) including first (102) and second (104) device structures. The first device structure (102) includes a first substrate (106), a first interconnection layer (108), a first dielectric layer (110) and a second interconnection layer (112). The first substrate (106) is formed on the first interconnection layer (108), the first interconnection layer (108) is formed on the first dielectric layer (110) and the first dielectric layer (110) is formed on the second interconnection layer (112). The second device structure (104) includes a second substrate (114), a third interconnection layer (116), a second dielectric layer (118) and a fourth interconnection layer (120). The second substrate (114) is formed on the third interconnection layer (116), the third interconnection layer (116) is formed on the second dielectric layer (118) and the second dielectric layer (118) is formed on the fourth interconnection layer (120).

## Description

### BACKGROUND

### Technical Field

The present disclosure relates to a double-sided cooled (DSC) package and, in particular, a DSC package that provides immersive cooling.

### Description of the Related Art

Single-sided packages that include multiple devices experience thermal coupling between the devices. The thermal coupling may be mitigated using a large ceramic substrate prepared using active metal brazing (AMB). However, the complexity of the layout and the patterning of the single-sided package means that the AMB ceramic substrate will be large. Increasing the size of the AMB ceramic substrate results in increasing the cost of the package.

### BRIEF SUMMARY

Provided is a hybrid double-sided cooled (DSC) package. The hybrid DSC package includes a first device structure. The first device structure includes a first substrate, a first interconnection layer, a first dielectric layer and a second interconnection layer. The first substrate is formed on the first interconnection layer, the first interconnection layer is formed on the first dielectric layer, and the first dielectric layer is formed on the second interconnection layer. The hybrid DSC package includes a second device structure. The second device structure includes a second substrate, a third interconnection layer, a second dielectric layer and a fourth interconnection layer. The second substrate is formed on the third interconnection layer, the third interconnection layer is formed on the second dielectric layer, and the second dielectric layer is formed on the fourth interconnection layer.

In an embodiment, the first substrate is fabricated using silicon (Si), gallium nitride (GaN) or gallium arsenide (GaAs) and is not fabricated using silicon carbide (SiC). In an embodiment, the second substrate is fabricated using silicon carbide (SiC) and not fabricated using silicon (Si), gallium nitride (GaN) or gallium arsenide (GaAs). In an embodiment, the first dielectric layer is formed using aluminum oxide (Al2O3) and does not include aluminum nitride (AlN).

In an embodiment, the second dielectric layer is formed using aluminum nitride (AlN) and does not include aluminum oxide (Al2O3).

In an embodiment, die soldering or wire bonding are used in the first and second interconnection layers.

In an embodiment, die soldering or wire bonding are used in the third and fourth interconnection layers.

In an embodiment, the first device structure and the second device structure are molded and are positioned on opposite sides of the hybrid DSC package. Provided is a converter including the hybrid DSC package.

Provided is a method including forming a first device structure of a hybrid double-sided cooled (DSC) package by forming a first substrate, forming a first interconnection layer, forming a first dielectric layer and forming a second interconnection layer. The first substrate is formed on the first interconnection layer, the first interconnection layer is formed on the first dielectric layer, and the first dielectric layer is formed on the second interconnection layer. The method includes forming a second device structure of the hybrid DSC package by forming a second substrate, forming a third interconnection layer, forming a second dielectric layer and forming a fourth interconnection layer. The second substrate is formed on the third interconnection layer, the third interconnection layer is formed on the second dielectric layer, and the second dielectric layer is formed on the fourth interconnection layer.

### BRIEF DESCRIPTION OF THE SEVERAL VIEWS OF THE DRAWINGS

- Figure 1: shows a hybrid DSC package.
- Figure 2: shows a block diagram of charging an electric vehicle.

### DETAILED DESCRIPTION

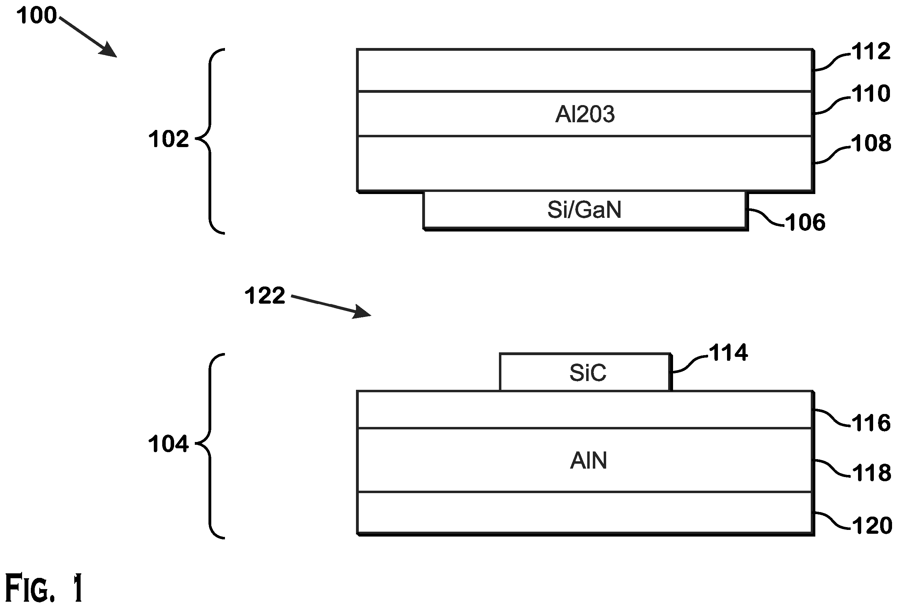

Figure 1 shows a hybrid double-sided cooled (DSC) package 100. The hybrid DSC package has different package technologies and different device technologies. The package 100 has first and second device structures 102, 104. The first and second device structures 102, 104 may be positioned opposite each other. The first device structure 102 may be an upper device structure of the package and the second device structure 104 may be a lower device structure of the package in the double-sided configuration. Alternatively, the device structure 102 may be a lower device structure and the second device structure 104 may be an upper device structure of the package in the double-sided configuration.

The first device structure 102 is fabricated using a first substrate, such as silicon (Si), gallium nitride (GaN) or gallium arsenide (GaAs). The second device structure 104 is fabricated using a second substrate, such as silicon carbide (SiC). Greater heat sinking and thermal isolation capabilities are implemented to facilitate use of the SiC substrate than the silicon (Si), gallium nitride (GaN) or gallium arsenide (GaAs).

The first structure 102 includes the first substrate 106 formed on a first interconnection layer 108. A first dielectric layer 110 is formed between the first interconnection layer 108 and a second interconnection layer 112. The first and second interconnection layers 108, 112 may be copper wire bonding layers, aluminum wire bonding layers or die soldering layers. The first dielectric layer 110 may be composed of aluminum oxide (Al2O3).

Die soldering uses solder (such as, tin-lead (Sn-Pb), tin-silver-copper (Sn-Ag-Cu), or eutectic gold-tin (Au-Sn), among others) to attach the first substrate 106 to the first interconnection layer 108. Wire bonding uses aluminum or copper wires to electrically connect the first substrate 106 to the first interconnection layer 108. Die soldering and wire bonding may also be used in the first and second interconnection layers 108, 112. As described herein, clip soldering and die sintering may not be used in the first and second interconnection layers 108, 112.

The second structure 104 includes the second substrate 114 formed on a third interconnection layer 116. A second dielectric layer 118 is formed between the third interconnection layer 116 and a fourth interconnection layer 120. The third and fourth interconnection layers 116, 120 may be clip soldering and die sintering layers. The second dielectric layer 118 may be composed of aluminum nitride (AlN).

Clip soldering and die sintering have higher reliability than die soldering and wire bonding. Clip soldering uses thicker copper or silver clips instead of thin wires to connect the second structure 104. The clips have a lower resistance and carry more current than their wire counterparts. Clip soldering is associated with an improved thermal performance and reliability than wire bonding and die soldering.

Die sintering uses sintered materials to attach the second substrate 114. Die sintering allows for improved thermal conductivity, electrical performance and mechanical robustness as compared to wire bonding and die soldering. Clip soldering and die sintering may be exclusively used in the third and fourth interconnection layers 116, 120 and may not be used in the first and second interconnection layers 108, 112.

The first substrate 106 (of Si, GaN or GaAs) may have a larger area than the second substrate 114 (of SiC). The first substrate 106 may be the main layout of the package 100 and be three times the size of the second substrate 114. SiC has high power density and can handle high current. The use of SiC relies on the second dielectric layer 118 of the second structure 104 having higher thermal conductivity, heat spreading, cooling and insulation, which increases the cost of the second dielectric layer 118. Furthermore, SiC itself is commercially more expensive than Si, GaN or GaAs.

The SiC area may be reduced by increasing the size of the Si area. Reducing the size of the SiC area also results in reducing the size of the second dielectric layer 118. Because Si is commercially less expensive than SiC, a better tradeoff is achieved by increasing the size of the Si area and its associated first dielectric layer 110.

The second substrate 114 may dissipate more heat than the first substrate 106 and require better cooling than the first substrate 106. The second dielectric layer 118 of the second structure 104 may have greater thermal isolation and heat dissipation capability than the first dielectric layer 110 of the first structure 102. To enable the greater thermal isolation and heat dissipation capability the second dielectric layer 118 of the second structure 104 may be composed of AlN, which has superior isolation and dissipation capability to that of Al2O3. AlN has a thermal conductivity of 120-170 watts per meter Kelvin (W/m·K). Al2O3 has a thermal conductivity of 25 W/m·K. Further, AlN has a coefficient of thermal expansion of 4.5*10⁻⁶ C°, whereas Al2O3 has a coefficient of thermal expansion of 8.1*10⁻⁶ C°.

For example, the second dielectric layer 118 may be composed exclusively of AlN and may not include Al2O3. Commercially, AlN is more costly than Al2O3. However, given that the area of the second substrate 114 is less than the area of the first substrate 106, cost savings are achieved by using AlN in the second dielectric layer 118 of the second structure 104 and refraining from using AlN in the first dielectric layer 110 of the first structure 102. Limiting the use of AlN in the package 100 to the second structure 104 (and not the first structure 102) achieves both suitable heat dissipation and thermal isolation for the second substrate 114 and commercial viability. Further, the use of AlN in the package 100 may be limited to the second structure 104 (and not the first structure 102). Because the second substate 114 is smaller in area than the first substrate 106, the second dielectric layer 118 is smaller in area than the first dielectric layer 110.

The first and second device structures 102, 104 may be molded for encapsulation within the package 100 using a mold 122. The mold 122 may be epoxy or a resin compound. The mold 122 may retain the first and second device structures 102, 104 on opposite sides of the hybrid DSC package 100 as shown in Figure 1.

It is noted that the hybrid DSC package 100 allows for direct attachment to a heatsink without the use of an isolation material provided by a technique like active metal brazing (AMB). The hybrid DSC package 100 leverages immersive cooling to eliminate the need for the expensive active metal brazing.

Silicon nitride (SiN or Si3N4) may be used in the second dielectric layer 118 in place of AlN. SiN has a thermal conductivity of 30 W/m·K and a coefficient of thermal expansion of 3.3*10⁻⁶ C°. Thus, SiN provides thermal conductivity and isolation that are more advantageous to use with a SiC die than Al2O3.

The hybrid DSC package 100 may be used in the power modules of an electric vehicle. For example, the hybrid DSC package 100 may be used in a traction inverter that converts DC power supplied from a battery to AC power to be provided to a motor. Further, the hybrid DSC package 100 may be used in the on-board charger of the vehicle and its DC-DC converters.

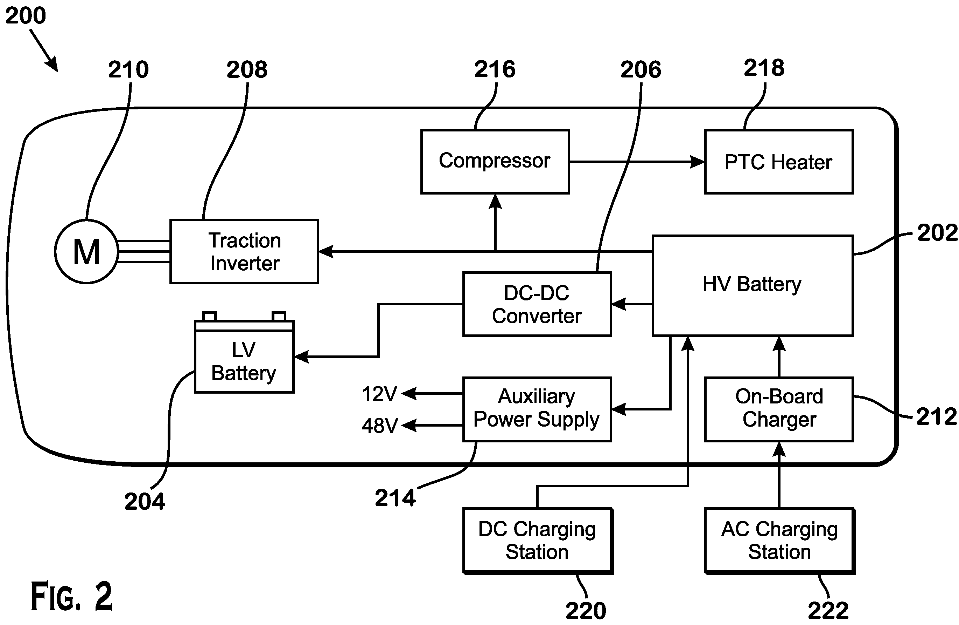

Figure 2 shows a block diagram of charging an electric vehicle 200. The electric vehicle 200 includes a high voltage (HV) battery 202. The HV battery 202 may be a DC battery and may have a voltage between 200 and 800 volts (V). The electric vehicle 200 includes a low voltage (LV) battery 204. The LV battery 204 may be a DC battery and may have a voltage that is lower than the voltage of the HV battery 202. The electric vehicle 200 includes a DC-DC converter 206, a traction inverter 208, a motor 210, an on-board charger 212, an auxiliary power supply 214, a compressor 216 and a heater 218. The motor may be an AC motor.

The electric vehicle 200 may be connected to a DC charging station 220 and an AC charging station 222. For example, the DC charging station 220 may be a fast DC charger. Each station 220, 222 may include a cable and a connector that is couplable to a respective vehicle inlet on the electric vehicle 200.

In the electric vehicle 200, the on-board charger 212 receives power from the AC charging station 222. The on-board charger 212 supplies the received power to the HV battery 202. The HV battery 202 also receives power directly from the DC charging station 220. The HV battery 202 stores the received power. The HV battery 202 is coupled to the DC-DC converter 206, the traction inverter 208 and the auxiliary power supply 214. The HV battery 202 supplies the stored power to the DC-DC converter 206, the traction inverter 208 and the auxiliary power supply 214.

The DC-DC converter 206 is coupled to the LV battery 204. The DC-DC converter 206 converts DC voltage received from the HV battery 202 to a lower voltage and supplies the lower voltage to the LV battery 204.

The traction inverter 208 is coupled to the motor 210. The traction inverter 208 inverts the DC voltage received from the HV battery 202 and generates AC voltage. The traction inverter 208 supplies the AC voltage to the motor 210. The auxiliary power supply 214 is coupled to the HV battery 202. The auxiliary power supply 214 may supply a lower DC voltage (such as, 12V and 48V) to components and outlets of the vehicle 200. The HV battery 202 also supplies DC power to the compressor 216. The compressor 216 drives the Positive Temperature Coefficient (PTC) heater 218.

The circuits of the high-voltage to low-voltage DC-DC converter 206, the traction inverter 208 and the on-board charger 212 may each include a power module. The power module of each inverter/converter may include the hybrid double-sided cooled package 100 described herein. For example, the hybrid double-sided cooled package 100 may be used to perform the control and switching that operates the low voltage DC-DC converter 206, the traction inverter 208 or the on-board charger 212.

The present application provides techniques for embedding and immersive cooling that forgoes the use of isolation material, such as AMB SiN. Further, the present application allows for direct attachment to a heatsink without isolation material. The use of the package described herein in switching operations leads to a short interconnection and a full stripline overlap for a DC+ DC- structure leading to low switching losses and high switching speed. For example, the high side and low side switches of a converter may be placed in a sandwich configuration.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A hybrid double-sided cooled, DSC, package (100), comprising:
a first device structure (102) including:
a first substrate (106);
a first interconnection layer (108);
a first dielectric layer (110); and
a second interconnection layer (112), wherein the first substrate (106) is formed on the first interconnection layer (108), the first interconnection layer (108) is formed on the first dielectric layer (110), and the first dielectric layer (110) is formed on the second interconnection layer (112); and
a second device structure (104) including:
a second substrate (114);
a third interconnection layer (116);
a second dielectric layer (118); and
a fourth interconnection layer (120), wherein the second substrate (114) is formed on the third interconnection layer (116), the third interconnection layer (116) is formed on the second dielectric layer (118), and the second dielectric layer (118) is formed on the fourth interconnection layer (120).

2. The hybrid DSC package (100) of claim 1, wherein the first substrate (106) is fabricated using silicon, gallium nitride or gallium arsenide and is not fabricated using silicon carbide.

3. The hybrid DSC package (100) of any of the previous claims, wherein the second substrate (114) is fabricated using silicon carbide and not fabricated using silicon, gallium nitride or gallium arsenide.

4. The hybrid DSC package (100) of any of the previous claims, wherein the first dielectric layer (110) is formed using aluminum oxide and does not include aluminum nitride.

5. The hybrid DSC package (100) of any of the previous claims, wherein the second dielectric layer (118) is formed using aluminum nitride and does not include aluminum oxide.

6. The hybrid DSC package (100) of any of the previous claims, wherein die soldering or wire bonding are used in the first interconnection layer (108) and in the second interconnection layer (112).

7. The hybrid DSC package (100) of any of the previous claims, wherein die soldering or wire bonding are used in the third interconnection layer (116) and in the fourth interconnection layer (120).

8. The hybrid DSC package (100) of any of the previous claims, wherein the first device structure (102) and the second device structure (104) are molded and are positioned on opposite sides of the hybrid DSC package (100).

9. A converter (206, 208, 212), comprising:
a hybrid DSC package (100) according to any of the previous claims.

10. A method, comprising:
forming a first device structure (102) of a hybrid double-sided cooled, DSC, package (100) by:
forming a first substrate (106);
forming a first interconnection layer (108);
forming a first dielectric layer (110); and
forming a second interconnection layer (112), wherein the first substrate (106) is formed on the first interconnection layer (108), the first interconnection layer (108) is formed on the first dielectric layer (110), and the first dielectric layer (110) is formed on the second interconnection layer (112); and
forming a second device structure (104) of the hybrid DSC package (100) by:
forming a second substrate (114);
forming a third interconnection layer (116);
forming a second dielectric layer (118); and
forming a fourth interconnection layer (120), wherein the second substrate (114) is formed on the third interconnection layer (116), the third interconnection layer (116) is formed on the second dielectric layer (118), and the second dielectric layer (118) is formed on the fourth interconnection layer (120).

11. The method of claim 10, wherein:
the first substrate (106) is fabricated using silicon, gallium nitride or gallium arsenide and is not fabricated using silicon carbide; and/or
the second substrate (114) is fabricated using silicon carbide and not fabricated using silicon, gallium nitride or gallium arsenide.

12. The method of claim 10 or claim 11, wherein:
the first dielectric layer (110) is formed using aluminum oxide and does not include aluminum nitride; and/or
the second dielectric layer (118) is formed using aluminum nitride and does not include aluminum oxide.

13. The method of any of claims 10 to 12, wherein die soldering or wire bonding are used in the first interconnection layer (108) and in the second interconnection layer (112).

14. The method of any of claims 10 to 13, wherein die soldering or wire bonding are used in the third interconnection layer (116) and in the fourth interconnection layer (120).

15. The method of any of claims 10 to 14, comprising molding and positioning on opposite sides of the hybrid DSC package (100) the first device structure (102) and the second device structure (104).
